(19) Europäisches Patentamt
European Patent Office
Office européen des brevets

(11) **EP 1 308 862 B1**

(12) **EUROPEAN PATENT SPECIFICATION**

(45) Date of publication and mention
of the grant of the patent:
**15.07.2009 Bulletin 2009/29**

(51) Int Cl.:
***G06F 17/50*** *(2006.01)*

(21) Application number: **01610111.5**

(22) Date of filing: **29.10.2001**

(54) **Optimization of the design of a synchronous digital circuit**

Optimierung des Entwurfs einer synchronen digitalen Schaltung

Optimisation de la conception d'un circuit numérique synchrone

(84) Designated Contracting States:
**AT BE CH CY DE DK ES FI FR GB GR IE IT LI LU MC NL PT SE TR**

(43) Date of publication of application:
**07.05.2003 Bulletin 2003/19**

(73) Proprietor: **TELEFONAKTIEBOLAGET LM ERICSSON (publ)**
**164 83 Stockholm (SE)**

(72) Inventor: **Lindkvist, Hans**
**224 72 Lund (SE)**

(74) Representative: **Boesen, Johnny Peder et al**
**Zacco Denmark A/S**
**Hans Bekkevolds Allé 7**
**2900 Hellerup (DK)**

(56) References cited:
WO-A-00/75815          US-A- 5 764 528
US-A- 5 983 007          US-A1- 2001 007 144
US-A1- 2001 010 092

- SOYATA T ET AL: "Synchronous performance and reliability improvement in pipelined ASICs" ASIC CONFERENCE AND EXHIBIT, 1994. PROCEEDINGS., SEVENTH ANNUAL IEEE INTERNATIONAL ROCHESTER, NY, USA 19-23 SEPT. 1994, NEW YORK, NY, USA,IEEE, 19 September 1994 (1994-09-19), pages 383-390, XP010140451 ISBN: 0-7803-2020-4
- SATHYAMURTHY H ET AL: "SPEEDING UP PIPELINED CIRCUITS THROUGH A COMBINATION OF GATE SIZING AND CLOCK SKEW OPTIMIZATION" IEEE TRANSACTIONS ON COMPUTER AIDED DESIGN OF INTEGRATED CIRCUITS AND SYSTEMS, IEEE INC. NEW YORK, US, vol. 17, no. 2, February 1998 (1998-02), pages 173-181, XP000802814 ISSN: 0278-0070
- SOYATA T ET AL: "Integration of clock skew and register delays into a retiming algorithm" PROCEEDINGS OF THE INTERNATIONAL SYMPOSIUM ON CIRCUITS AND SYSTEMS. (ISCS). CHICAGO, MAY 3 - 6, 1993, NEW YORK, IEEE, US, vol. 2, 3 May 1993 (1993-05-03), pages 1483-1486, XP010115529 ISBN: 0-7803-1281-3

**Description**

Technical Field of the Invention

The invention relates to a method of modifying the design of a synchronous digital circuit comprising a number of clocked storage devices and a number of combinational logic elements defining combinational paths between at least some of said clocked storage devices, each combinational path from an output of a first one of said clocked storage devices to an input of a second one of said clocked storage devices having a minimum delay value and a maximum delay value, such that the actual delay of said path assumes a value between the minimum delay value and the maximum delay value. The invention further relates to a system for modifying the design of such a circuit, and to a computer readable medium having instructions for causing a processing unit to execute the method.

Description of Related Art

In digital synchronous circuits clock signals are used to synchronize computations. Digital signals are stored in storage elements awaiting a synchronizing clock pulse. The storage elements are typically interconnected by combinational logic. Each storage element delays the signal by a single clock period. Synchronizing the storage elements with clock signals reduces the uncertainty in delay between sending and receiving signals in the storage elements. The storage elements, such as registers, latches and flip-flops, sample output signals of the combinational logic, preserve the values internally as the state of the circuit, and make the state available for new computations after a certain delay.
Pushing the frequency of the clock signal of a digital synchronous circuit towards higher frequencies to obtain a higher rate of calculation in the logic has been, is still, and will most likely continue to be one of the most important optimization objectives in the design of digital synchronous circuits.
Most current schemes for optimizing the maximal clock frequency of digital circuits are focused on circuits with so-called zero-skew or minimal skew clock distribution. This zero-skew or minimal skew clock distribution is based on distributing clock signals to storage elements concentrating on ensuring a high degree of synchronism of all clock signals. The clock signals are typically distributed in a tree-like structure, whereby delays in different branches can be balanced to a high degree. The major benefit of such schemes is that uniformity brings predictability and simplifies the overall design problem. Zero-skew or minimal skew clock distribution is e.g. known from US 5 122 679, US 5 852 640 and US 6 025 740. However, the performance of this kind of circuit is limited by the longest combinatorial delay among local paths between any pair of storage elements.
Alternatives to the zero- and minimal-skew clock distribution scheme exist, but are less frequently used. In unidirectional pipelines it is common practice to distribute the clock signal in the direction opposite to the data flow. However, complex ASIC designs are rarely suitable for this method, since their data flow is complex and irregular.
Performance tuning through intentional clock skew is also used, either through explicit designer decisions to redistribute computation time between two pipeline stages, or through the use of special CAD tools, such as the tool "Clockwise" offered by Ultima Interconnect Technologies. The theoretical limit for the performance of an intentional clock skew scheme should be defined by the mean value of the longest delays in the loop having the highest mean value of the longest delays. However, practice has shown that the highest obtainable clock frequency is considerably lower than the theoretical limit, because it is also limited by other factors.
The intentional clock skew scheme is also used in combination with other methods. H. Sathyamurthy et al, "Speeding up Pipelined Circuits through a Combination of Gate Sizing and Clock Skew Optimization" describes an algorithm in which manipulation of clock skew is combined with gate sizing, i.e. reduction of the delay of e.g. a gate by changing the dimensions of the transistors of the gate. However, gate sizing implies an increased circuit area and a higher power dissipation of the circuit. T. Soyata et al, "Integration of Clock Skew and Register Delays into a Retiming Algorithm" (0-7803-1254-5/93), IEEE, 1993 combines the use of clock skew with a retiming process in which registers of a synchronous circuit are relocated within the circuit in order to achieve a higher clock frequency. This relocation of registers is a very complex process for complicated circuits, because the relocation of a register typically requires the use of several new registers to replace the one that was relocated.
Therefore, it is an object of the invention to provide a method of the above-mentioned type in which the clock frequency of a synchronous digital circuit can be increased in a relatively simple way without the use of the very complex or power consuming methods mentioned above.

Summary

According to the invention the object is achieved in that the method comprises the steps of identifying the combinational path having the largest difference between the maximum delay value and the minimum delay value, and reducing said difference between the maximum delay value and the minimum delay value by increasing the minimum delay value for said combinational path having the largest difference.

The minimum delay value of a combinational path can often be increased easily, and thus this is a very simple way of reducing the difference between the maximum delay value and the minimum delay value. Since the greatest one of these difference values can be shown to be the lower limit for the usable clock period, a reduction will allow a shorter clock period and thus a higher clock frequency of the circuit.

When the greatest difference in case of parallel paths is calculated as the difference between the highest maximum delay value and the lowest minimum delay value, it is ensured that the situation where one path has the lowest minimum delay value and another the highest maximum delay value is also taken into account. When further the maximum delay value for a sequential path is calculated as the sum of the maximum delay values for the paths comprised in the sequential path, and the minimum delay value for a sequential path is calculated as the sum of the minimum delay values for the paths comprised in the sequential path, also this situation can be taken into account.

When the step of increasing the minimum delay value for a combinational path is performed by inserting a number of buffers in the combinational path, a very simple and cost effective method is achieved.

When the method further comprises the steps of identifying among sequential paths from an input to an output of the circuit and sequential paths defining loops in the circuit the sequential path having the highest mean value of the maximum delay values, calculating said highest mean value of the maximum delay values, identifying those paths for which the difference between the maximum delay value and the minimum delay value exceeds said highest mean value of the maximum delay values, and reducing said differences exceeding the highest mean value of the maximum delay values to be less than or equal to said highest mean value of the maximum delay values, it is possible to design circuits that can be clocked with the highest possible clock frequency, because the highest mean value of the maximum delay values is the lower limit for the clock period for a circuit where the input and the output should be clocked simultaneously, or for circuits in which loops occur due to feed-back couplings.

As mentioned, the invention also relates to a system for modifying the design of a synchronous digital circuit comprising a number of clocked storage devices and a number of combinational logic elements defining combinational paths between at least some of said clocked storage devices, each combinational path from an output of a first one of said clocked storage devices to an input of a second one of said clocked storage devices having a minimum delay value and a maximum delay value, such that the actual delay of said path assumes a value between the minimum delay value and the maximum delay value.

When the system comprises means for identifying the combinational path having the greatest difference between the maximum delay value and the minimum delay value, and means for reducing said difference between the maximum delay value and the minimum delay value by increasing the minimum delay value for said combinational path having the largest difference, the system will be able to increase the clock frequency of a synchronous digital circuit in a relatively simple way without the use of the very complex or power consuming methods mentioned above. The minimum delay value of a combinational path can often be increased easily, and thus this is a very simple way of reducing the difference between the maximum delay value and the minimum delay value. Since the greatest one of these difference values can be shown to be the lower limit for the usable clock period, a reduction will allow a shorter clock period and thus a higher clock frequency of the circuit.

When the system is adapted to calculate the largest difference in case of parallel paths as the difference between the highest maximum delay value and the lowest minimum delay value, it is ensured that the situation where one path has the lowest minimum delay value and another the highest maximum delay value is also taken into account. When the system is further adapted to calculate the maximum delay value for a sequential path as the sum of the maximum delay values for the paths comprised in the sequential path, and to calculate the minimum delay value for a sequential path as the sum of the minimum delay values for the paths comprised in the sequential path, also this situation can be taken into account.

When the system is adapted to increase the minimum delay value for a combinational path by the insertion of a number of buffers in the combinational path, a simple and cost effective system is achieved.

When the system further comprises means for identifying among sequential paths from an input to an output of the circuit and sequential paths defining loops in the circuit the sequential path having the highest mean value of the maximum delay values, means for calculating said highest mean value of the maximum delay values, means for identifying those paths for which the difference between the maximum delay value and the minimum delay value exceeds said highest mean value of the maximum delay values, and means for reducing said differences exceeding the highest mean value of the maximum delay values to be less than or equal to said highest mean value of the maximum delay values, it is possible to design circuits that can be clocked with the highest possible clock frequency, because the highest mean value of the maximum delay values is the lower limit for the clock period for a circuit where the input and the output should be clocked simultaneously, or for circuits in which loops occur due to feed-back couplings.

As mentioned, the invention further relates to a computer readable medium having stored therein instructions for causing a processing unit to execute the above method. With this medium a system as described above can be implemented on a normal computer.

## EP 1 308 862 B1

Brief Description of the Drawings

The invention will now be described more fully below with reference to the drawings, in which

figure 1 shows a synchronous digital circuit in which the invention can be applied,

figure 2 shows an example of a combinational circuit that can be used in the circuit of figure 1,

figure 3 shows the circuit of figure 1 with examples of specific values of the delays,

figure 4 shows a timing diagram for the circuit of figure 3,

figure 5 shows an alternative timing diagram for the circuit of figure 3,

figure 6 shows the circuit of figure 3 modified with intentional clock skew,

figure 7 shows a timing diagram for the circuit of figure 6,

figure 8 shows a table of difference values calculated for the circuit of figure 6,

figure 9 shows the combinational circuit of figure 2 modified to have a longer minimum delay value,

figure 10 shows a table of difference values calculated with extended minimum delay values,

figure 11 shows the circuit of figure 6 modified according to the table of figure 10,

figure 12 shows a timing diagram for the circuit of figure 11,

figure 13 shows an alternative table of difference values calculated with extended minimum delay values,

figure 14 shows the circuit of figure 6 modified according to the table of figure 13,

figure 15 shows a timing diagram for the circuit of figure 14,

figure 16 shows the circuit of figure 1 with alternative examples of specific values of the delays,

figure 17 shows a timing diagram for the circuit of figure 16,

figure 18 shows a table of difference values calculated for the circuit of figure 16,

figure 19 shows a timing diagram for the circuit of figure 16 modified with intentional clock skew,

figure 20 shows a table of difference values for the circuit of figure 16 calculated with extended minimum delay value for one path,

figure 21 shows a timing diagram for the circuit of figure 16 modified according to the table of figure 20,

figure 22 shows a table of difference values for the circuit of figure 16 calculated with extended minimum delay values for two paths,

figure 23 shows the circuit of figure 16 modified according to the table of figure 22, and

figure 24 shows a timing diagram for the circuit of figure 23.

Detailed Description of Embodiments

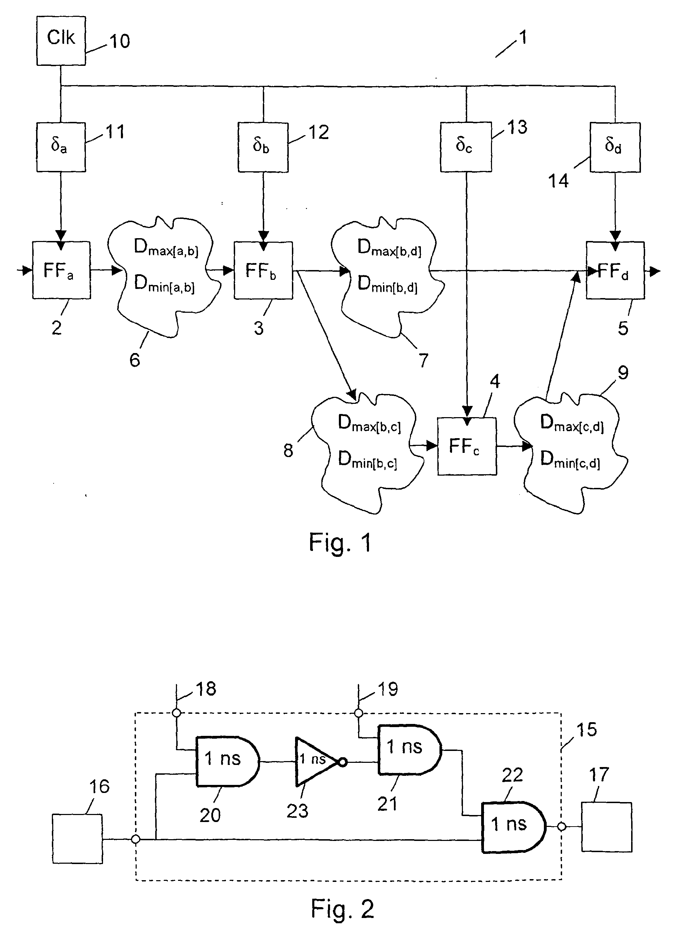

Figure 1 illustrates an example of a synchronous digital circuit 1 having four registers 2, 3, 4, and 5 and four blocks of combinational logic 6, 7, 8 and 9. The registers 2, 3, 4, and 5 are also designated $FF_a$, $FF_b$, $FF_c$ and $FF_d$, and they are clocked from a clock source 10. The clock is subjected to certain insertion delays $\delta_a$, $\delta_b$, $\delta_c$ and $\delta_d$, indicated by the delay blocks 11, 12, 13 and 14, as it is distributed to the registers.

Each of the combinational logic blocks 6, 7, 8 and 9 delays the digital signals passing through them. The delay of a combinational logic block, i.e. the delay from the output of one register to the input of another register, may vary between a shortest combinational delay $D_{min}$ and a longest combinational delay $D_{max}$. Thus the delay of e.g. the block 6, i.e. the delay from the output of register $FF_a$ to the input of register $FF_b$, may vary between a shortest combinational delay $D_{min[a,b]}$ and a longest combinational delay $D_{max[a,b]}$.

Very often $D_{min}$ is considerably smaller than $D_{max}$ which is illustrated by the combinational circuit 15 shown in figure 2 which could be any of the combinational logic blocks 6, 7, 8 and 9 in figure 1. The circuit 15 is connected between the output of a register 16 and the input of another register 17, and it is further connected to two external signals 18 and 19. These signals may be asynchronous signals or synchronous signals. However, we assume that they are stable when a change propagates through the circuit. The circuit 15 comprises the AND gates 20, 21 and 22 and an inverter 23. Each gate and inverter is supposed to have a delay of one nanosecond. It is seen that if the output from register 16 e.g. changes from a "1" to a "0" in a situation where the output of the circuit 15 is a "1", the output will change to a "0" independent of the rest of the circuit already after 1 ns because the signal only has to propagate through gate 22. Thus $D_{min[16,17]}$ is 1 ns. In other situations, however, the output signal will also depend on the external signals 18 and 19, the gates 20, 21 and the inverter 23, and it will have to propagate through all gates/inverters before the output is ready. This will take 4 ns and thus $D_{max[16,17]}$ is 4 ns.

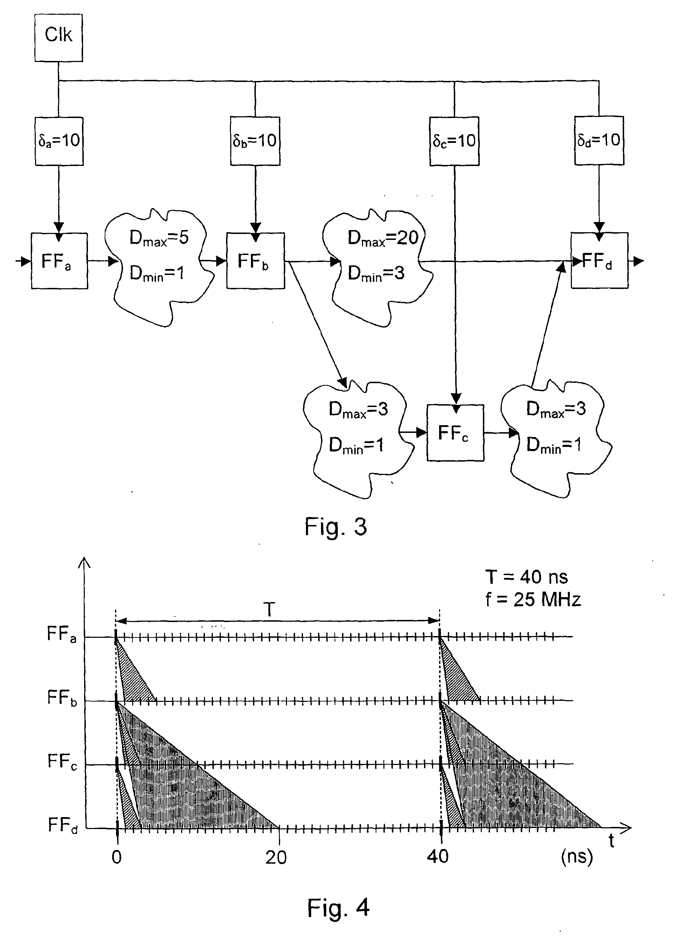

Figure 3 shows the circuit of figure 1 with specific values of the longest and shortest combinational delays and of the insertion delays of the clock signals. It is seen that all four insertion delays are set to 10 ns corresponding to a traditional zero-skew clocking scheme. Figure 4 illustrates how the timing of the circuit could be.

It should be noted that for reasons of simplicity the time required for the data at the input of a register to latch, i.e. the set-up time, and the time required for the data to appear at the output of the register upon arrival of the clock signal are not taken into account. The same is true for the hold time of the register. In practice these times should also be considered, which will complicate the exact calculations but not change any of the following conclusions.

In the example the clock frequency is chosen to 25 MHz, corresponding to a clock period of 40 ns, which is well below the maximum clock frequency of the circuit. At the time t = 0 all four registers are clocked, and their output signals are ready. If we look at the combinational logic block connecting the output of $FF_a$ to the input of $FF_b$, $D_{min[a,b]}$ is 1 ns and $D_{max[a,b]}$ is 5 ns, which means that the input of $FF_b$ may change already after 1 ns but it may also take up to 5 ns before it is ready. This is illustrated by the shaded area in the upper part of figure 4. Similarly, the signal from $FF_b$ to $FF_c$ will arrive between 1 and 3 ns, the signal from $FF_c$ to $FF_d$ also between 1 and 3 ns, and the signal from $FF_b$ to $FF_d$ (i.e. the direct route) between 3 and 20 ns, which is also illustrated with shaded areas. It is seen that after 20 ns (i.e.

$D_{max[b,d]}$) all input signals to the registers are ready for the next clock pulse to arrive.

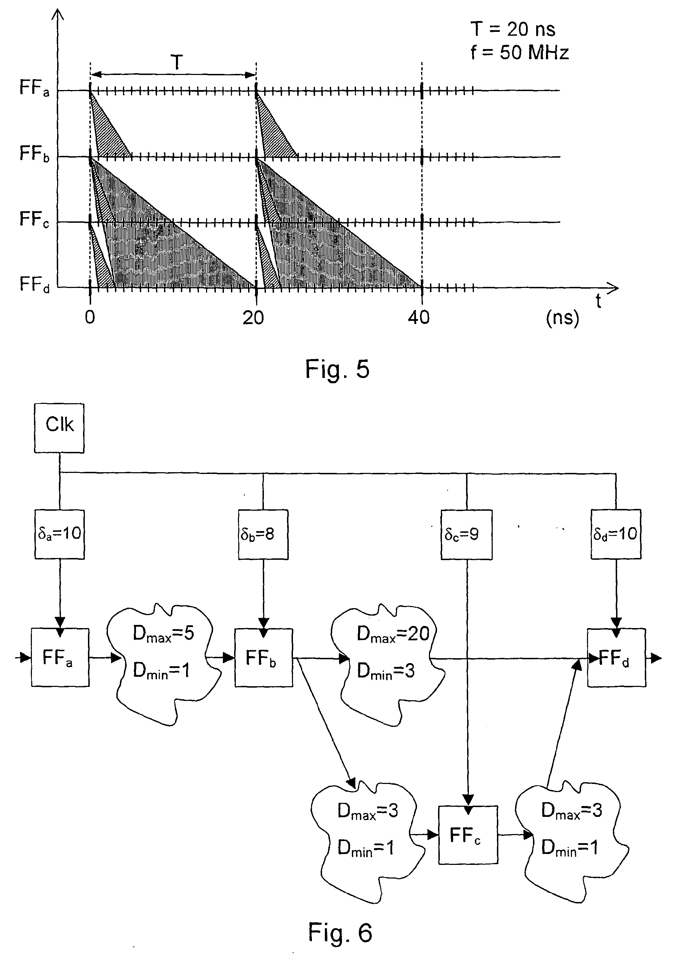

Thus the clock period (T) in figure 4 can be reduced from the 40 ns to any value down to 20 ns. Values below 20 ns are not possible because $FF_d$ should not be clocked before its input signal is guaranteed to be ready. The situation with the clock period reduced to 20 ns, i.e. the clock frequency increased to 50 MHz, is shown in figure 5. It is supposed that $D_{max[b,d]}$ cannot be reduced below the 20 ns, and thus 50 MHz is the highest obtainable clock frequency when zero-skew is used.

However, intentional clock skew allows the clock frequency to be increased further. Intentional clock skew means that the registers are allowed to be clocked at different times, i.e. the registers will have different $\delta$ values. Registers $FF_a$ and $FF_d$ will normally have to be clocked simultaneously because they represent the input and the output of the entire circuit, but it is seen from figure 5 that the registers $FF_b$ and $FF_c$ may be clocked earlier, because the data at their inputs have been ready for 15 and 17 ns, respectively, prior to the arrival of the clock pulse. Especially, if $FF_b$ is clocked earlier, the data at the input of $FF_d$ would be ready earlier, and $FF_d$ could thus be clocked earlier with a reduction of the clock period being the result.

Although $FF_a$ and $FF_d$ are normally clocked simultaneously, as mentioned, it is noted that this is not a necessary condition for the following considerations.

The basic requirements for clock scheduling for the circuit to function correctly can be formulated in the following expressions for all values of i, j where there is a combinational path from the output of register i to the input of register j, and where T is the clock cycle time:

$$\delta_i - \delta_j \leq T - D_{max[i,j]} \qquad (1)$$

$$\delta_i - \delta_j \geq -D_{min[i,j]}. \qquad (2)$$

According to (1) $FF_i$ may be clocked later than $FF_j$ (positive skew), but not more than $T - D_{max[i,j]}$, because then the data would not reach $FF_j$ before the next clock signal. According to (2) $FF_i$ may be clocked before $FF_j$ (negative skew), but not more than $D_{min[i,j]}$, because then the data would reach $FF_j$ before it is clocked, i.e. a race condition would occur.

The requirement (1) can be used to calculate the smallest usable T. Since (1) must be true for any values of i, j, i.e. for any path from the output of one register to the input of another, it also must be true for combined paths. Thus $\Sigma(\delta_i - \delta_j) \le \Sigma(T - D_{max[i,j]})$ for any combined path.

As an example, the circuit of figure 3 has two combined paths from its input to its output, i.e. the paths a - b - d (which will be used in the following to denote the path from register $FF_a$ through register $FF_b$ to register $FF_d$) and a - b - c - d, and thus

$$(\delta_a - \delta_b) + (\delta_b - \delta_d) \le (T - D_{max[a,b]}) + (T - D_{max[b,d]})$$

and

$$(\delta_a - \delta_b) + (\delta_b - \delta_c) + (\delta_c - \delta_d)$$
$$\le (T - D_{max[a,b]}) + (T - D_{max[b,c]}) + (T - D_{max[c,d]}).$$

Since $\delta_a$ is supposed to be equal to $\delta_d$, as mentioned above, these expressions can be rewritten to:

$$\delta_a - \delta_d = 0 \le 2T - (D_{max[a,b]} + D_{max[b,d]})$$

and

$$\delta_a - \delta_d = 0 \le 3T - (D_{max[a,b]}) + D_{max[b,c]} + D_{max[c,d]}),$$

or

$$T \ge (D_{max[a,b]} + D_{max[b,d]}) / 2$$

and

$$T \ge (D_{max[a,b]}) + D_{max[b,c]} + D_{max[c,d]}) / 3.$$

Generally, the expression

$$T \ge \Sigma(D_{max[i,j]}) / n \qquad (3)$$

must be true for any combination of paths, where n is the number of paths in the combined path.

This means that the clock period must be selected higher than the mean value of $D_{max}$ for a loop or a path from input to output of the circuit, and since this must be true for any such path, T must be greater than the mean value of $D_{max}$ for the loop/path with the highest mean value of the $D_{max}$ values. For the circuit of figure 3 this means that $T \ge$ (5 ns + 20 ns) / 2 = 12.5 ns. Thus the smallest obtainable value of T can be calculated for any circuit of the above-mentioned type from these expressions.

The idea behind intentional clock skew is that the combinational block having the longest $D_{max}$ in the loop or path with the longest total sum of the $D_{max}$ values can "borrow" some of the time not utilized (so-called slack) by the other blocks of that loop/path, as long as the above requirement (3) is fulfilled.

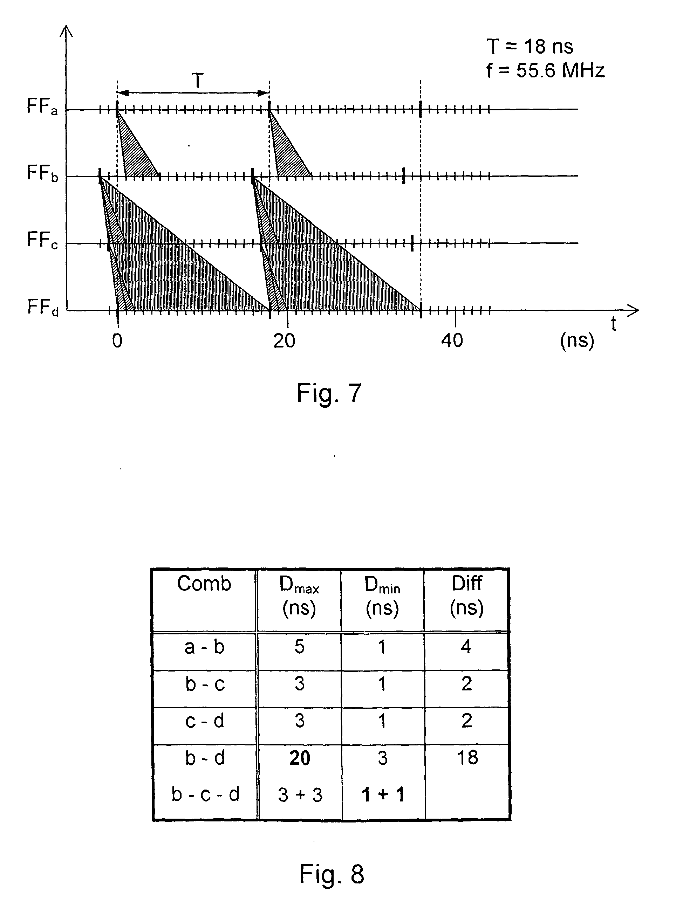

Therefore, ideally it should be possible to reduce the clock period of the circuit of figure 3 to 12.5 ns. However, it is easily seen from figure 5 that this would cause a race condition to occur because the signal going from $FF_b$ via $FF_c$ to $FF_d$ would arrive at $FF_d$ too early. Intuitively it can be seen that in order to avoid this race condition the intentional clock skew must be limited to the values which are shown in figures 6 and 7, because the clock frequency is actually also limited by the shortest combinational delays, not only the longest. The clock period can only be reduced to 18 ns corresponding to a clock frequency of 55.6 MHz. Although a clock period of 18 ns is better than the original 20 ns, it is still far from the ideal value of 12.5 ns.

It will be seen from figure 7 that the problem is not that the combinational logic connecting $FF_b$ to $FF_d$ has a long $D_{max}$, but rather the big difference between $D_{max}$ and $D_{min}$ (including the parallel route via $FF_c$), because a clock period below this difference is not possible when race conditions are to be avoided. This can also be seen from the requirements (1) and (2). When requirements (1) and (2) are combined, it is found for any values of i, j that:

$$-D_{min[i,j]} \leq T - D_{max[i,j]}, \qquad \text{or} \qquad T \geq D_{max[i,j]} - D_{min[i,j]}. \qquad (4)$$

Thus if the ideal lowest value of T calculated above violates (4), the lowest value of T will instead be limited by this expression. This is also called the "stiffness" of the circuit. Since also this expression must be true for any path of the circuit, the lowest usable clock period can be found by calculating the difference $D_{max} - D_{min}$ for each combinational block in the circuit. In case of parallel and/or sequential routes (like $FF_b$ - $FF_d$ and $FF_b$ - $FF_c$ - $FF_d$ in the example of figures 3 and 6) the sum of the $D_{max}$ values and the sum of the $D_{min}$ values for each route are calculated, and then $-\Sigma D_{min[i,j]} \leq (n_{max} \cdot T) - \Sigma D_{max[i,j]}$ must be true for any of the parallel routes, where $n_{max}$ is the number of sequential paths, i.e. the number of clock periods in the route for which $\Sigma D_{max[i,j]}$ is calculated. The limiting value is then calculated as the highest $\Sigma D_{max}$ minus the lowest $\Sigma D_{min}$ divided by the number of clock periods ($n_{max}$) in the route with the highest $\Sigma D_{max}$. Thus the clock period which can be obtained by intentional clock skewing is limited by the formula

$$T \geq \frac{\max\left[\sum D_{max}\right] - \min\left[\sum D_{min}\right]}{n_{max}}. \qquad (5)$$

In the table of figure 8 the difference values (Diff) according to (5) has been calculated for each combinational block in the circuit (Comb), and as the highest difference value is 18 ns, this will also be the limit for T in good correspondence with figure 7.

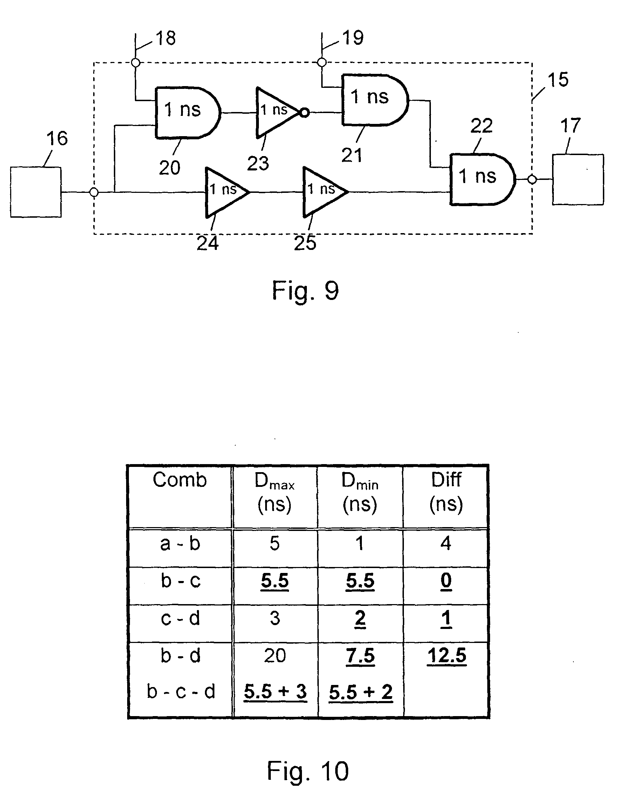

It follows from the above that if the clock period should be reduced further, the mentioned difference values also need to be reduced. It is supposed that the $D_{max}$ values cannot be reduced, or they are supposed to be reduced already as much as they can. However, according to the invention it will often be possible to increase the $D_{min}$ values without increasing the $D_{max}$ values, and that has the desired effect of reducing the difference values. Figure 9 shows an example of how this can be done with the circuit from figure 2. In figure 9 the circuit has been modified by the insertion of two buffers 24 and 25 between the input of the circuit and the AND gate 22. When these buffers have a delay of 1 ns similar to the other gates, it is seen that $D_{min}$ for the circuit is increased from 1 ns to 3 ns while $D_{max}$ is unchanged 4 ns. Thus the difference value for the circuit has been reduced from 3 ns to 1 ns.

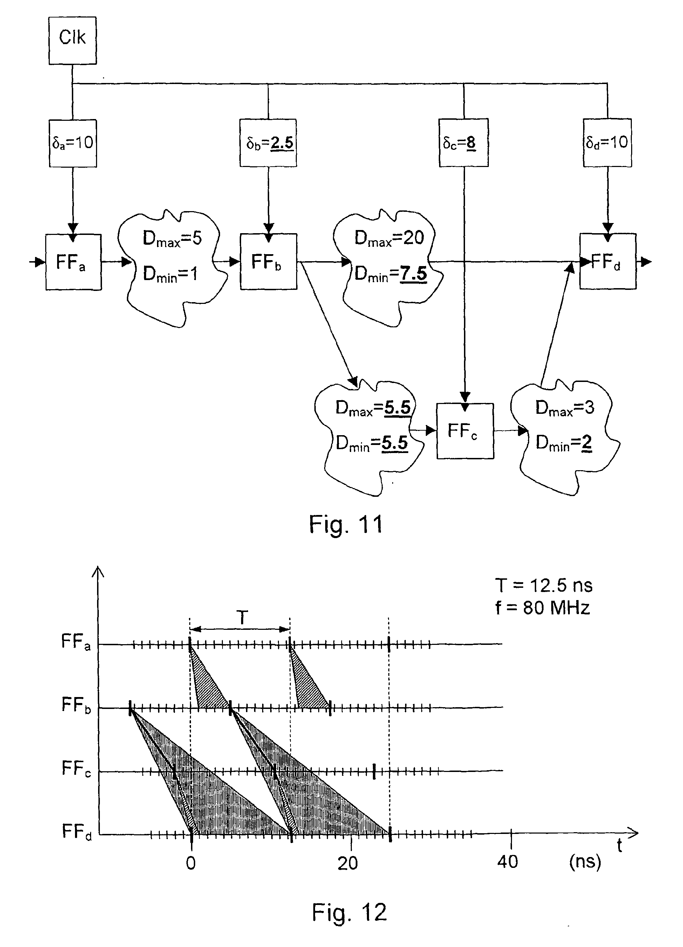

It can be seen from the table of figure 8 that in order to obtain the ideal value of the clock period of 12.5 ns corresponding to a clock frequency of 80 MHz defined by the longest delays as mentioned above, the $D_{min}$ value for the path b - c - d must be extended to 7.5 ns. To avoid path b - d from becoming the new restriction, its $D_{min}$ value must be extended to 7.5 ns as well. Since $D_{max}$ must be greater than or equal to $D_{min}$ for any path, $D_{max[b,c]}$ must also be extended, but that can be done without any influence on the result, because the value is small compared to the longest delays. The result is shown in the table of figure 10. The corresponding circuit and timing diagram are shown in figures 11 and 12.

It will also be seen from figure 12 why the clock period cannot be reduced to values below 12.5 ns when the registers $FF_a$ and $FF_d$ have to be clocked simultaneously, as will normally be a requirement from surrounding circuitry. $D_{max[a,b]} + D_{max[b,d]}$ must be less than two clock periods, or in other words the clock period cannot be less than the mean value of $D_{max}$ for the path having the longest total delay, as has been mentioned earlier.

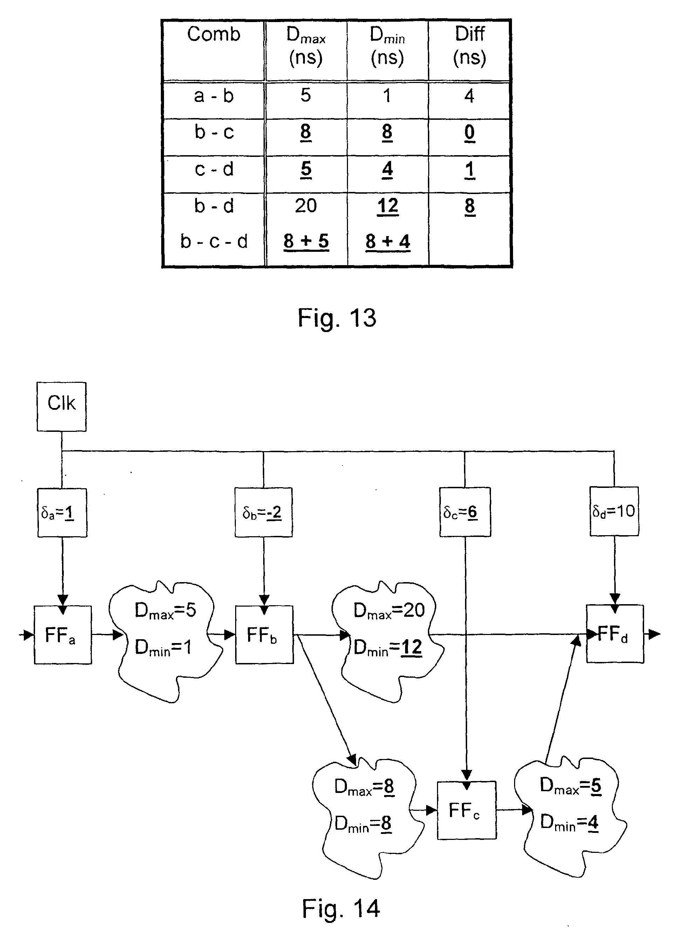

If, however, this requirement does not exist, the clock period can be reduced further. An example is illustrated in figures 13, 14 and 15 in which the clock period has been reduced to 8 ns corresponding to a clock frequency of 125 MHz. However it must be noted that in this example the clock skew exceeds the clock period, and this will only be possible when no external circuits require synchronism between the input and the output.

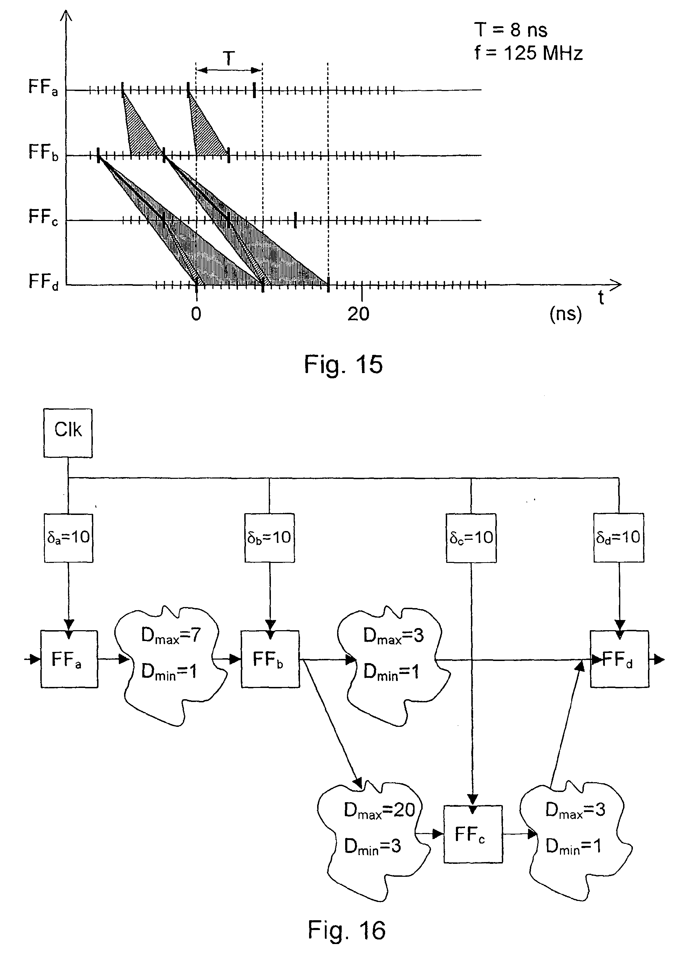

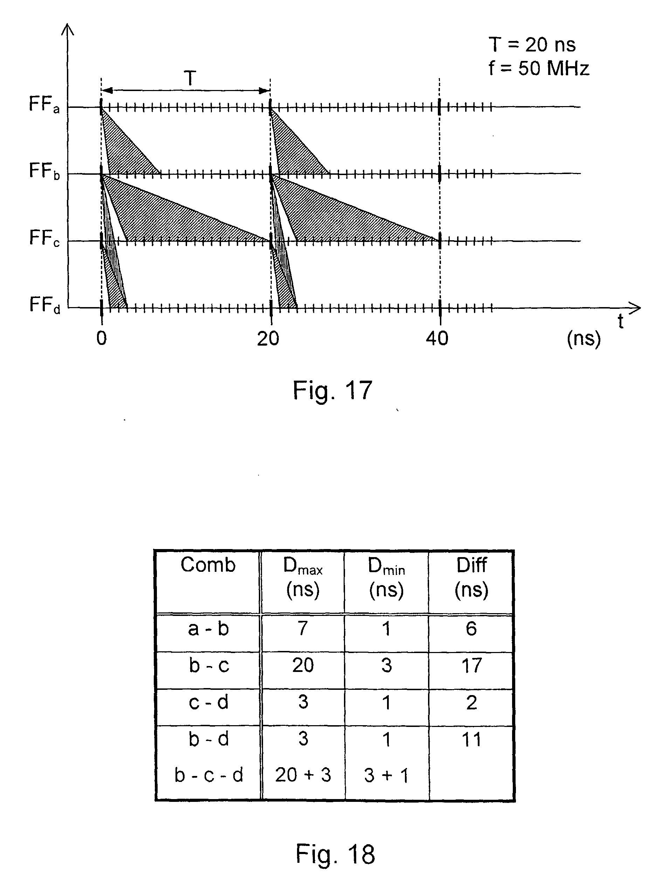

To illustrate the calculation of the obtainable clock periods, another example will be briefly described. Figure 16 shows a circuit similar to that of figure 3, but now the longest delay is located between $FF_b$ and $FF_c$. With zero-skew clocking the shortest clock period is again 20 ns because $D_{max[b,c]}$ = 20 ns, and the timing is shown in figure 17.

First the optimal clock period according to (3) is calculated. If it is again supposed that $FF_a$ and $FF_d$ must be clocked simultaneously, the path with the longest delay is a - b - c - d, and the mean value of $D_{max}$ for this path is (7 + 20 + 3) / 3 = 10 ns, and thus the clock period cannot be reduced below this value.

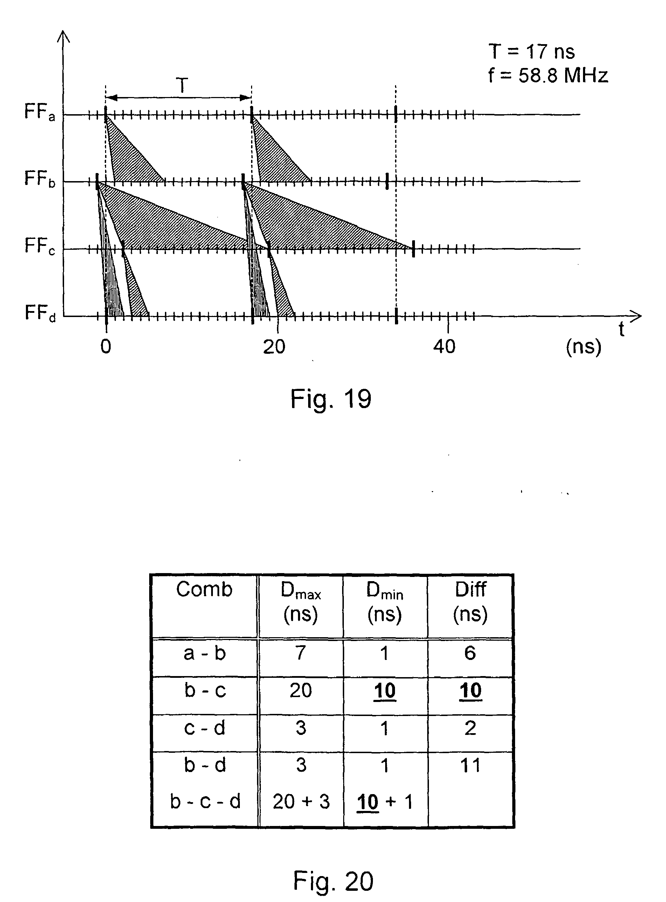

The difference values according to (5) are calculated in the table of figure 18. Here it is especially noted that the value for the two parallel paths from $FF_b$ to $FF_d$ is calculated as ((20 + 3) - 1) / 2 = 11 ns according to formula (5) above, because the highest sum of the $D_{max}$ values has two components. The highest difference value is 17 ns for the path b - c, and thus with the conventional intentional skew scheme the clock period can be reduced to 17 ns as shown in the timing diagram of figure 19.

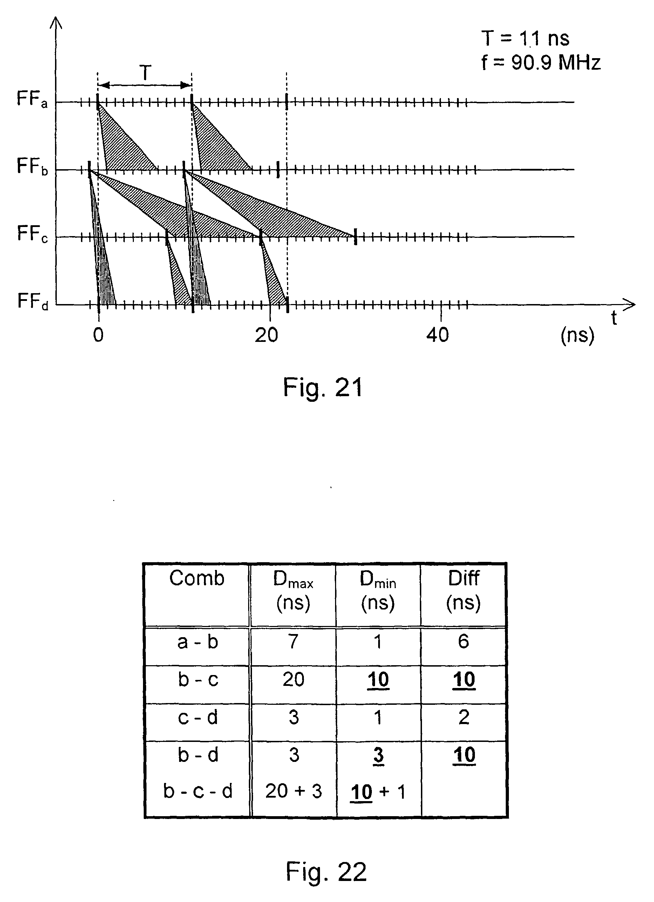

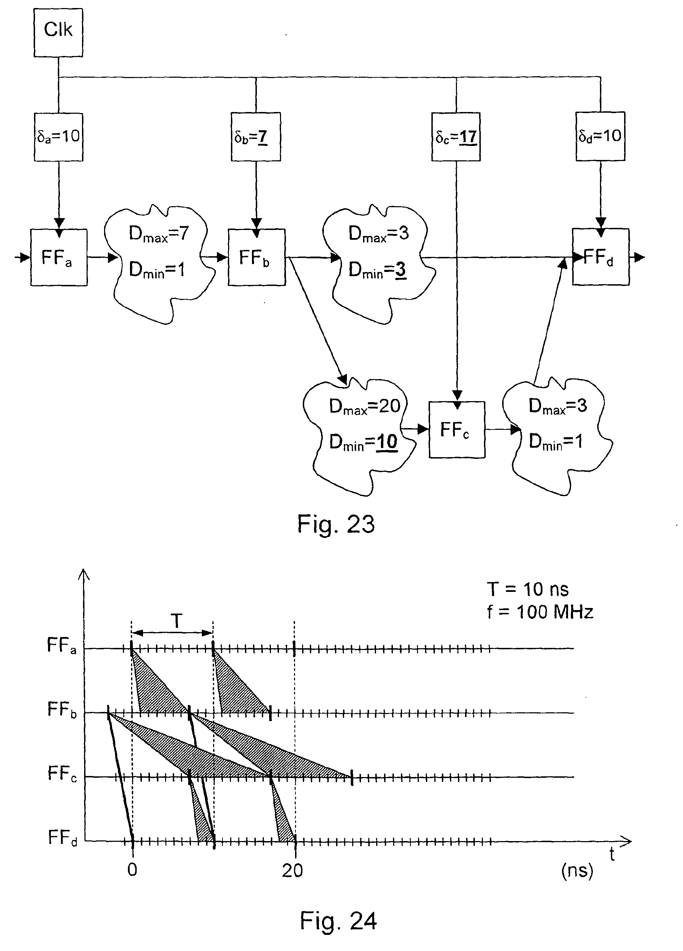

In order to reduce the clock period further according to the invention, the highest difference value of 17 ns for the path b - c must be reduced to 10 ns, and therefore $D_{min[b,c]}$ is increased to 10 ns. The result is shown in figures 20 and 21, from which it will be seen that now the difference value for the path b - d/b - c - d (11 ns) is the limiting factor. Consequently, also this difference value has to be reduced, and $D_{min[b,d]}$ is therefore increased to 3 ns. The final result is shown in the table of figure 22 and the corresponding circuit in figure 23. The timing is illustrated in figure 24.

In the above examples it has been described how much the clock period can be reduced. However, it should be mentioned that the idea of the invention is to reduce the clock period, and thus increase the clock frequency, but not necessarily as much as possible. In the example just mentioned above, the clock period could be reduced from 17 ns to 10 ns. If, for example, a clock period of 15 ns is needed, a good and safe solution could be to extend $D_{min[b,c]}$ from 3 ns to 6 ns, which would allow a clock period of 14 ns, thus providing one extra nanosecond as a safety margin.

As illustrated in figure 9, one way of increasing the shortest delay between two registers is to insert one or more cascaded buffers somewhere in the combinational path between the two registers. However, several other possibilities exist, and some of them are:

- cascaded buffers at the output of sending register
- cascaded buffers at the input of receiving register
- resizing and rearranging combinatorial gates
- latch immediately downstream of the output of the sending register
- latch immediately upstream of the input of the receiving register
- replacing sending register with one with built-in second slave stage, i.e. sending out on opposite edge compared to the receiver sampling and its own input
- replacing receiving register with one with built-in second master stage, i.e. sampling on opposite edge compared to the sender and its own output
- a combination of any of the above.

It should be noted that the invention as described above can be used in the design of a circuit from the beginning, or it can be used to improve an existing circuit. Thus a circuit can be designed by using the existing methods of clock skew scheduling while ignoring the expression (5) in order to obtain an optimal schedule. Then afterwards those of the shortest delays showing a race condition can be increased according to the invention.

**Claims**

1. A method of modifying the design of a synchronous digital circuit (1) comprising a number of clocked storage devices (2, 3, 4, 5) and a number of combinational logic elements defining combinational paths (6, 7, 8, 9) between at least some of said clocked storage devices, each combinational path from an output of a first one of said clocked storage devices to an input of a second one of said clocked storage devices having a minimum delay value ($D_{min}$) and a maximum delay value ($D_{max}$), such that the actual delay of said path assumes a value between the minimum delay value and the maximum delay value,
   **characterized in that** the method comprises the steps of

   • identifying the combinational path (6; 7; 8; 9) having the greatest difference between the maximum delay value ($D_{max}$) and the minimum delay value ($D_{min}$), and
   • reducing said difference between the maximum delay value and the minimum delay value by increasing the

minimum delay value ($D_{min}$) for said combinational path having the largest difference.

2. A method according to claim 1, **characterized in that** the greatest difference in case of parallel paths is calculated as the difference between the highest maximum delay value and the lowest minimum delay value.

3. A method according to claim 2, **characterized in that** the maximum delay value for a sequential path is calculated as the sum of the maximum delay values for the paths comprised in the sequential path, and that the minimum delay value for a sequential path is calculated as the sum of the minimum delay values for the paths comprised in the sequential path.

4. A method according to any one of claims 1 to 3, **characterized in that** the step of increasing the minimum delay value for a combinational path is performed by inserting a number of buffers (24, 25) in the combinational path.

5. A method according to any one of claims 1 to 4, **characterized in that** it further comprises the steps of

   • identifying among sequential paths from an input to an output of the circuit and sequential paths defining loops in the circuit the sequential path having the highest mean value of the maximum delay values ($D_{max}$),
   • calculating said highest mean value of the maximum delay values,
   • identifying those paths for which the difference between the maximum delay value and the minimum delay value exceeds said highest mean value of the maximum delay values, and
   • reducing said differences exceeding the highest mean value of the maximum delay values to be less than or equal to said highest mean value of the maximum delay values.

6. A system for modifying the design of a synchronous digital circuit (1) comprising a number of clocked storage devices (2, 3, 4, 5) and a number of combinational logic elements defining combinational paths (6, 7, 8, 9) between at least some of said clocked storage devices, each combinational path from an output of a first one of said clocked storage devices to an input of a second one of said clocked storage devices having a minimum delay value ($D_{min}$) and a maximum delay value ($D_{max}$), such that the actual delay of said path assumes a value between the minimum delay value and the maximum delay value,
   **characterized in that** the system comprises

   • means for identifying the combinational path (6; 7; 8; 9) having the greatest difference between the maximum delay value ($D_{max}$) and the minimum delay value ($D_{min}$), and
   • means for reducing said difference between the maximum delay value and the minimum delay value by increasing the minimum delay value ($D_{min}$) for said combinational path having the greatest difference.

7. A system according to claim 6, **characterized in that** it is adapted to calculate the greatest difference in case of parallel paths as the difference between the highest maximum delay value and the lowest minimum delay value.

8. A system according to claim 7, **characterized in that** it is adapted to calculate the maximum delay value for a sequential path as the sum of the maximum delay values for the paths comprised in the sequential path, and to calculate the minimum delay value for a sequential path as the sum of the minimum delay values for the paths comprised in the sequential path.

9. A system according to any one of claims 6 to 8, **characterized in that** it is adapted to increase the minimum delay value for a combinational path by the insertion of a number of buffers (24, 25) in the combinational path.

10. A system according to any one of claims 6 to 9, **characterized in that** it further comprises

   • means for identifying among sequential paths from an input to an output of the circuit and sequential paths defining loops in the circuit the sequential path having the highest mean value of the maximum delay values ($D_{max}$),
   • means for calculating said highest mean value of the maximum delay values,
   • means for identifying those paths for which the difference between the maximum delay value and the minimum delay value exceeds said highest mean value of the maximum delay values, and
   • means for reducing said differences exceeding the highest mean value of the maximum delay values to be less than or equal to said highest mean value of the maximum delay values.

**11.** A computer readable medium having stored therein instructions for causing a processing unit to execute the method of any one of claims 1 to 5.

**Patentansprüche**

**1.** Verfahren zum Abwandeln des Entwurfs eines synchronen digitalen Schaltkreises (1) mit einer Anzahl von getakteten Speichervorrichtungen (2, 3, 4, 5) und einer Anzahl von Verknüpfungslogikelementen, die Verknüpfungswege (6, 7, 8, 9) zwischen wenigstens einigen der getakteten Speichervorrichtungen festlegen, wobei jeder Verknüpfungsweg von einem Ausgang einer ersten der getakteten Speichervorrichtungen zu einem Eingang einer zweiten der getakteten Speichervorrichtungen einen minimalen Verzögerungswert ($D_{min}$) und einen maximalen Verzögerungswert ($D_{max}$) aufweist, so dass die tatsächliche Verzögerung des Weges einen Wert zwischen dem minimalen Verzögerungswert und dem maximalen Verzögerungswert annimmt,
**dadurch gekennzeichnet, dass** das Verfahren die Schritte umfasst

• Bestimmen des Verknüpfungswegs (6; 7; 8; 9) mit der größten Differenz zwischen dem maximalen Verzögerungswert ($D_{max}$) und dem minimalen Verzögerungswert ($D_{min}$), und
• Reduzieren der Differenz zwischen dem maximalen Verzögerungswert und dem minimalen Verzögerungswert durch Erhöhen des minimalen Verzögerungswerts ($D_{min}$) für den Verknüpfungsweg mit der größten Differenz.

**2.** Verfahren nach Anspruch 1, **dadurch gekennzeichnet, dass** die größte Differenz im Fall von parallelen Wegen als die Differenz zwischen dem höchsten maximalen Verzögerungswert und dem niedrigsten minimalen Verzögerungswert berechnet wird.

**3.** Verfahren nach Anspruch 2, **dadurch gekennzeichnet, dass** der maximale Verzögerungswert für einen fortlaufenden Weg als die Summe der maximalen Verzögerungswerte für die im fortlaufenden Weg enthaltenen Wege berechnet wird, und dass der minimale Verzögerungswert für einen fortlaufenden Weg als die Summe der minimalen Verzögerungswerte für die im fortlaufenden Weg enthaltenen Wege berechnet wird.

**4.** Verfahren nach einem der Ansprüche 1 bis 3, **dadurch gekennzeichnet, dass** der Schritt des Erhöhens des minimalen Verzögerungswerts für einen Verknüpfungsweg durch Einfügen einer Anzahl von Puffern (24, 25) in den Verknüpfungsweg ausgeführt wird.

**5.** Verfahren nach einem der Ansprüche 1 bis 4, **dadurch gekennzeichnet, dass** es ferner die Schritte umfasst

• Bestimmen unter fortlaufenden Wegen von einem Eingang zu einem Ausgang des Schaltkreises und fortlaufenden Wegen, die Schleifen im Schaltkreis festlegen, den fortlaufenden Weg mit dem höchsten Mittelwert der maximalen Verzögerungswerte ($D_{max}$),
• Berechnen des höchsten Mittelwertes der maximalen Verzögerungswerte,
• Bestimmen jener Wege, für die die Differenz zwischen dem maximalen Verzögerungswert und dem minimalen Verzögerungswert den höchsten Mittelwert der maximalen Verzögerungswerte überschreitet, und
• Reduzieren der den höchsten Mittelwert der maximalen Verzögerungswerte überschreitenden Differenzen auf weniger als den oder gleich dem höchsten Mittelwert der maximalen Verzögerungswerte.

**6.** System zum Abwandeln des Entwurfs eines synchronen digitalen Schaltkreises (1) mit einer Anzahl von getakteten Speichervorrichtungen (2, 3, 4, 5) und einer Anzahl von Verknüpfungslogikelementen, die Verknüpfungswege (6, 7, 8, 9) zwischen wenigstens einigen der getakteten Speichervorrichtungen festlegen, wobei jeder Verknüpfungsweg von einem Ausgang einer ersten der getakteten Speichervorrichtungen zu einem Eingang einer zweiten der getakteten Speichervorrichtungen einen minimalen Verzögerungswert ($D_{min}$) und einen maximalen Verzögerungswert ($D_{max}$) aufweist, so dass die tatsächliche Verzögerung des Weges einen Wert zwischen dem minimalen Verzögerungswert und dem maximalen Verzögerungswert annimmt,
**dadurch gekennzeichnet, dass** das System umfasst

• ein Mittel zum Bestimmen des Verknüpfungswegs (6; 7; 8; 9) mit der größten Differenz zwischen dem maximalen Verzögerungswert ($D_{max}$) und dem minimalen Verzögerungswert ($D_{min}$), und
• ein Mittel zum Reduzieren der Differenz zwischen dem maximalen Verzögerungswert und dem minimalen Verzögerungswert durch Erhöhen des minimalen Verzögerungswerts ($D_{min}$) für den Verknüpfungsweg mit der größten Differenz.

**7.** System nach Anspruch 6, **dadurch gekennzeichnet, dass** es ausgebildet ist, die größte Differenz im Fall von parallelen Wegen als die Differenz zwischen dem höchsten maximalen Verzögerungswert und dem niedrigsten minimalen Verzögerungswert zu berechnen.

**8.** System nach Anspruch 7, **dadurch gekennzeichnet, dass** es ausgebildet ist, den maximalen Verzögerungswert für einen fortlaufenden Weg als die Summe der maximalen Verzögerungswerte für die im fortlaufenden Weg enthaltenen Wege zu berechnen, und den minimalen Verzögerungswert für eine fortlaufenden Weg als die Summe der minimalen Verzögerungswerte für die im fortlaufenden Weg enthaltenen Wege zu berechnen.

**9.** System nach einem der Ansprüche 6 bis 8, **dadurch gekennzeichnet, dass** es ausgebildet ist, den minimalen Verzögerungswert eines Verknüpfungswegs durch das Einsetzen einer Anzahl von Puffern (24, 25) in den Verknüpfungsweg zu erhöhen.

**10.** System nach einem der Ansprüche 6 bis 9, **dadurch gekennzeichnet, dass** es ferner umfasst

• ein Mittel zum Bestimmen unter fortlaufenden Wegen von einem Eingang zu einem Ausgang des Schaltkreises und fortlaufenden Wegen, die Schleifen im Schaltkreis festlegen, den fortlaufenden Weg mit dem höchsten Mittelwert der maximalen Verzögerungswerte ($D_{max}$),
• ein Mittel zum Berechnen des höchsten Mittelwertes der maximalen Verzögerungswerte,
• ein Mittel zum Bestimmen jener Wege, für die die Differenz zwischen dem maximalen Verzögerungswert und dem minimalen Verzögerungswert den höchsten Mittelwert der maximalen Verzögerungswerte überschreitet, und
• ein Mittel zum Reduzieren der den höchsten Mittelwert der maximalen Verzögerungswerte überschreitenden Differenzen auf weniger als den oder gleich dem höchsten Mittelwert der maximalen Verzögerungswerte.

**11.** Computerlesbares Medium mit darauf gespeicherten Anweisungen, um eine Verarbeitungseinheit zu veranlassen, das Verfahren nach einem der Ansprüche 1 bis 5 auszuführen.

**Revendications**

**1.** Procédé de modification de la conception d'un circuit numérique synchrone (1) comportant un certain nombre de dispositifs de stockage cadencés (2, 3, 4, 5) et un certain nombre d'éléments logiques combinatoires définissant des chemins combinatoires (6, 7, 8, 9) entre au moins certains desdits dispositifs de stockage cadencés, chaque chemin combinatoire allant d'une sortie d'un premier desdits dispositifs de stockage cadencés à une entrée d'un second desdits dispositifs de stockage cadencés ayant une valeur de retard minimale ($D_{min}$) et une valeur de retard maximale ($D_{max}$), telles que le retard réel dudit chemin prenne une valeur comprise entre la valeur de retard minimale et la valeur de retard maximale,
le procédé étant **caractérisé en ce qu'**il comprend les étapes qui consistent :

• à identifier le chemin combinatoire (6 ; 7 ; 8 ; 9) ayant la plus grande différence entre la valeur de retard maximale ($D_{max}$) et la valeur de retard minimale ($D_{min}$), et
• à réduire ladite différence entre la valeur de retard maximale et la valeur de retard minimale en augmentant la valeur de retard minimale ($D_{min}$) pour ledit chemin combinatoire ayant la plus grande différence.

**2.** Procédé selon la revendication 1, **caractérisé en ce que** la plus grande différence dans le cas de chemins parallèles est calculée en tant que différence entre la valeur de retard maximale la plus élevée et la valeur de retard minimale la plus basse.

**3.** Procédé selon la revendication 2, **caractérisé en ce que** la valeur de retard maximale pour un chemin séquentiel est calculée en tant que somme des valeurs de retard maximales pour les chemins compris dans le chemin séquentiel, et **en ce que** la valeur de retard minimale pour un chemin séquentiel est calculée en tant que somme des valeurs de retard minimales pour les chemins compris dans le chemin séquentiel.

**4.** Procédé selon l'une quelconque des revendications 1 à 3, **caractérisé en ce que** l'étape d'augmentation de la valeur de retard minimale pour un chemin combinatoire est effectuée en insérant un nombre de tampons (24, 25) dans le chemin combinatoire.

**5.** Procédé selon l'une quelconque des revendications 1 à 4, **caractérisé en ce qu'**il comprend en outre les étapes qui consistent :

• à identifier parmi des chemins séquentiels allant d'une entrée à une sortie du circuit et des chemins séquentiels définissant des boucles dans le circuit, le chemin séquentiel ayant la valeur moyenne la plus élevée des valeurs de retard maximales ($D_{max}$),
• à calculer ladite valeur moyenne la plus élevée des retard maximales,
• à identifier les chemins pour lesquels la différence entre la valeur de retard maximale et la valeur de retard minimale dépasse ladite valeur moyenne la plus élevée des valeurs de retard maximales, et
• à réduire lesdites différences dépassant la valeur moyenne la plus élevée des valeurs de retard maximales afin qu'elles soient inférieures ou égales à ladite valeur moyenne la plus élevée des valeurs de retard maximales.

**6.** Système pour modifier la conception d'un circuit numérique synchrone (1) comportant un certain nombre de dispositifs de stockage cadencés (2, 3, 4, 5) et un certain nombre d'éléments logiques combinatoires définissant des chemins combinatoires (6, 7, 8, 9) entre au moins certains desdits dispositifs de stockage cadencés, chaque chemin combinatoire depuis une sortie d'un premier desdits dispositifs de stockage cadencés à une entrée d'un second desdits dispositifs de stockage cadencés ayant une valeur de retard minimale ($D_{min}$) et une valeur de retard maximale ($D_{max}$), telles que le retard réel dudit chemin prend une valeur comprise entre la valeur de retard minimale et la valeur de retard maximale,
le système étant **caractérisé en ce qu'**il comporte :

• un moyen destiné à identifier le chemin combinatoire (6 ; 7 ; 8 ; 9) ayant la plus grande différence entre la valeur de retard maximale ($D_{max}$) et la valeur de retard minimale ($D_{min}$), et
• un moyen destiné à réduire ladite différence entre la valeur de retard maximale et la valeur de retard minimale en augmentant la valeur de retard minimale ($D_{min}$) pour ledit chemin combinatoire ayant la plus grande différence.

**7.** Système selon la revendication 6, **caractérisé en ce qu'**il est conçu pour calculer la plus grande différence dans le cas de chemins parallèles en tant que la différence entre la valeur de retard maximale la plus élevée et la valeur de retard minimale la plus basse.

**8.** Système selon la revendication 7, **caractérisé en ce qu'**il est conçu pour calculer la valeur de retard maximale pour un chemin séquentiel en tant que la somme des valeurs de retard maximales pour les chemins compris dans le chemin séquentiel, et pour calculer la valeur de retard minimale pour un chemin séquentiel en tant que la somme des valeurs de retard minimales pour les chemins compris dans le chemin séquentiel.

**9.** Système selon l'une quelconque des revendications 6 à 8, **caractérisé en ce qu'**il est conçu pour augmenter la valeur de retard minimale pour un chemin combinatoire par l'insertion d'un certain nombre de tampons (24, 25) dans le chemin combinatoire.

**10.** Système selon l'une quelconque des revendications 6 à 9, **caractérisé en ce qu'**il comporte en outre :

• un moyen destiné à identifier parmi des chemins séquentiels allant d'une entrée à une sortie du circuit et des chemins séquentiels définissant des boucles dans le circuit, le chemin séquentiel ayant la valeur moyenne la plus élevée des valeurs de retard maximales ($D_{max}$),
• un moyen destiné à calculer ladite valeur moyenne la plus élevée des valeurs de retard maximales,
• un moyen destiné à identifier les chemins pour lesquels la différence entre la valeur de retard maximale et la valeur de retard minimale dépasse ladite valeur moyenne la plus élevée des valeurs de retard maximales, et
• un moyen destiné à réduire lesdites différences dépassant la valeur moyenne la plus élevée des valeurs de retard maximales afin qu'elles soient inférieures ou égales à ladite valeur moyenne la plus élevée des valeurs de retard maximales.

**11.** Support lisible par ordinateur dans lequel sont stockées des instructions pour amener une unité de traitement à exécuter le procédé selon l'une quelconque des revendications 1 à 5.

Fig. 1

Fig. 2

Fig. 3

Fig. 4

T = 20 ns
f = 50 MHz

Fig. 5

Fig. 6

15

Fig. 7

| Comb | $D_{max}$ (ns) | $D_{min}$ (ns) | Diff (ns) |
|---|---|---|---|
| a - b | 5 | 1 | 4 |
| b - c | 3 | 1 | 2 |
| c - d | 3 | 1 | 2 |
| b - d | **20** | 3 | 18 |
| b - c - d | 3 + 3 | **1 + 1** | |

Fig. 8

Fig. 9

| Comb | $D_{max}$ (ns) | $D_{min}$ (ns) | Diff (ns) |
|---|---|---|---|
| a - b | 5 | 1 | 4 |
| b - c | **5.5** | **5.5** | **0** |
| c - d | 3 | **2** | **1** |
| b - d | 20 | **7.5** | **12.5** |
| b - c - d | **5.5 + 3** | **5.5 + 2** | |

Fig. 10

Fig. 11

Fig. 12

| Comb | $D_{max}$ (ns) | $D_{min}$ (ns) | Diff (ns) |
|---|---|---|---|
| a - b | 5 | 1 | 4 |
| b - c | **8** | **8** | **0** |
| c - d | **5** | **4** | **1** |
| b - d | 20 | **12** | **8** |
| b - c - d | **8 + 5** | **8 + 4** | |

Fig. 13

Fig. 14

T = 8 ns
f = 125 MHz

Fig. 15

Fig. 16

T = 20 ns
f = 50 MHz

Fig. 17

| Comb | D$_{max}$ (ns) | D$_{min}$ (ns) | Diff (ns) |
|---|---|---|---|
| a - b | 7 | 1 | 6 |
| b - c | 20 | 3 | 17 |
| c - d | 3 | 1 | 2 |
| b - d | 3 | 1 | 11 |
| b - c - d | 20 + 3 | 3 + 1 | |

Fig. 18

21

T = 17 ns
f = 58.8 MHz

Fig. 19

| Comb | $D_{max}$ (ns) | $D_{min}$ (ns) | Diff (ns) |
|---|---|---|---|
| a - b | 7 | 1 | 6 |
| b - c | 20 | **10** | **10** |
| c - d | 3 | 1 | 2 |
| b - d | 3 | 1 | 11 |
| b - c - d | 20 + 3 | **10** + 1 | |

Fig. 20

T = 11 ns
f = 90.9 MHz

Fig. 21

| Comb | $D_{max}$ (ns) | $D_{min}$ (ns) | Diff (ns) |
|---|---|---|---|
| a - b | 7 | 1 | 6 |
| b - c | 20 | **10** | **10** |
| c - d | 3 | 1 | 2 |
| b - d | 3 | **3** | **10** |
| b - c - d | 20 + 3 | **10** + 1 | |

Fig. 22

Fig. 23

Fig. 24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5122679 A
- US 5852640 A
- US 6025740 A

**Non-patent literature cited in the description**

- **H. Sathyamurthy et al.** *Speeding up Pipelined Circuits through a Combination of Gate Sizing and Clock Skew Optimization*
- **T. Soyata et al.** *Integration of Clock Skew and Register Delays into a Retiming Algorithm,* 1993